# EUROPEAN PATENT APPLICATION

(11) **EP 4 383 019 A1**
(43) Date of publication of application: **12.06.2024**
(21) Application number: 22212252.5
(22) Date of filing: 08.12.2022
(51) Int. Cl.: G05B 13/02

(54) **VIRTUAL SENSOR**

(71) Applicant: Hitachi, Ltd., Tokyo 100-8280 (JP)
(72) Inventor: OHAZULIKE, Anthony, London EC2Y 5AJ (GB)
(74) Representative: MERH-IP Matias Erny Reichl Hoffmann Patentanwälte PartG mbB

(57) **Abstract**

A device 1 for determining values of parameters related to a machine, the device 1 comprising an input interface for receiving input data; one or more sets 2 of determination units 3, wherein each set 2 includes a plurality of determination units 3 and each determination unit 3 within one set 2 is configured to determine a value of a predetermined parameter for a target point based on the received input data, and wherein one or more determination units 3 from one set 2 are combined into a subset 5 of determination units 3 and each subset 5 is configured to determine a value of the predetermined parameter for a target point associated to the subset 5; and an output interface for outputting a value determined by the subset 5.

## Description

### Technical Field

The present disclosure relates, among others, to a device for the determination of values of parameters related to a machine, in particular it relates to a device which applies trained artificial intelligence or machine learning units for determining the parameter values. Such device can be used as a virtual sensor and/or control device. More specifically, the devices provided in this disclosure in particular relate to a device for monitoring and/or controlling an electric motor where the parameters include the temperature of the electric motor at different positions as well as the state of health (SOH) of the electric motor, and a colling temperature or flow rate of a coolant.

### Background

Functioning of a machine or an apparatus including for instance a vehicle, a motor, a heat exchanger, a brake, a machine tool and the like involves usually complex factors including physical parameters of the machine which may be measured on different parts of the machine (i.e. spatially distributed), such as the temperature, pressure, electrical current or voltage, and so on. Further, these factors may also include control parameters provided for instance on the basis of the measured physical parameters for controlling of the functioning of the corresponding machine.

However, due to the sheer number of physical parameters and control parameters that may be involved in the functioning of the machine, it is a problem as to how to accurately determine those parameters that are necessary for providing for instance precise control commands for the machine to carry out corresponding actions.

In particular, the measurement of physical parameters with physical sensors may not be possible for each physical location of a machine, inter alia due to space restrictions and so on, which may lead to accuracy problems if, e.g., gradients of values of the physical parameters might be existing over a volume or area of the machine, and the determination of physical parameters based on physical models may not be able to accurately provide values for the physical parameters which are for instance constantly updating themselves in the course of the functioning of the machine.

This leads to lack of accuracy in the sensing of physical parameters and, thus, in regard of the controlling of the machine.

Therefore, trained artificial intelligence (Al) or machine learning (ML) units have been considered.

And, combining different types of AI/ML has been considered for increasing the accuracy, robustness, and so on of the output of the AI/ML. For example, the non-patent literature "Two-Stage Ensemble of Deep Convolutional Neural Networks for Object Recognition" Rom Uddamvathanak et al., 2018 International Conference on Intelligent Rail Transportation (ICIRT), 12-14 December 2018 provides a two-stage method of assembling CNN models (abbreviation used here for Convolutional Neural Networks) to increase the accuracy. In other words, the document describes assembling different AI/ML types/models to improve model accuracy and diversity. Nevertheless there are still unsolved problems especially in connection with the goal of the present disclosure, and in particular a device which can accurately determine physical parameter values of a machine and/or provide control parameter values is not envisaged by the above prior art.

However, it would be desirable to provide a solution for combining different trained machine learning units (ML) / artificial intelligence (Al) units/models which allow to determine values of physical parameters and/or of control parameters even for highly complex systems. One example of such applications may be, without limiting the present disclosure thereto:
1) How to model complex and high-dimensional heating and cooling phenomena of electric motors. Hence, obtain a more accurate and robust model that can estimate the temperatures at different target points of an engine or e-motor in real-time, to provide highly efficient thermal management control of an e-motor and/or enable effective and precise cooling.

It is the underlying object of the present disclosure to provide, in particular, a device for determining values of parameters related to a machine, wherein it is aimed to provide an accurate determination of complex and high-dimensional parameters of the machine, so as to obtain a more accurate and robust determination model that can determine/measure/simulate/estimate the corresponding parameters at different target points of the machine in real-time, thereby also enabling highly efficient controlling of the machine. More specifically and preferably, such machine is an electric motor and the parameters to be determined and/or used for control shall include the temperature of the electric motor, SOH and/or the cooling temperature or flow rate of the coolant.

In accordance with the present disclosure, there is provided a device for determining values of parameters related to a machine, which is preferably an electric motor. The parameters related to the machine may include, as explained before, physical parameters and/or control parameter (whereas control parameters may also be of physical nature), such as temperature, pressure, electrical current and so on in regard of the physical parameters and such as cooling temperature, coolant fluid flow rate, force, velocity, and so on in regard of the control parameters. The values of the parameters are numerical values which may be expressed in their respective units, such as Celsius, Kelvin, Pa, m/s, etc. Most preferably, the parameters include temperature, coolant flow rate, cooling temperature (which means the temperature required for achieving a target temperature of a point of the electric motor), and/or state of health (SOH) of the electric motor. SOH of the electric motor may be defined by, e.g., the ratio of an actual efficiency and the theoretical or start efficiency of the electric motor, or the like. For example, the actual efficiency might be measured by a sensor or a plurality of sensors which measure electric power at the input and the output where the efficiency is the ratio between the input and the output power value. The theoretical efficiency could also be considered as the efficiency determined like the "actual efficiency" however at the very start of the operation of the electric motor, such as directly after its assembly or after a maintenance or another defined time period.

The device may comprise an input interface for receiving input data. The input data may include the required data for determining the value of a parameter. In an example in which the temperature of an e-motor shall be determined at different target points or the SOH of the e-motor, both examples shall not limit the present disclosure, the input data may include room/ambient temperature values (around the electric motor such as measured or simulated during the operation of the electric motor), and the electric motor operational values, such as the actual values of the rotational speed, output power, and so on. More specifically, the input data of the electric motor temperature determination device and/or an SOH determination device, as the preferred examples of this disclosure, are at least the ambient temperature at time t (actual time) and the actual electric power output at the time t. More specifically, the preferred list of input data which may be measured, e.g., by sensors of the e-motor is: List of input data (measured): Ambient Temperature, Coolant (oil) temperature, Coolant (oil) flow rate at rotor, Coolant (oil) flow rate at Stator A side, Coolant (oil) flow rate at Stator B side, Speed Motor revolution, Operation time, Voltage (at various predefined points), Current (at predefined various points), List of (engineered) input data (derived from measured parameters): Torque (at predefined various points), electric Power, Force, Pressure, Pressure x Speed, Pressure x Speed x Time, Voltage x Current (at predefined various points) and Previous (at previous times) temperatures (at e.g. 54 different points of the e-motor or more or less points).

The device further comprising one or more sets of determination units, wherein each set includes a plurality of determination units and each determination unit within one set is configured to determine a value of a predetermined parameter for a target point based on the received input data, and wherein one or more determination units from one set are combined as a subset of determination units and each subset is configured to determine a value of the predetermined parameter for a target point associated to the subset. In other words, one or more subsets are provided in device which each include one or more of the determination units, where same determination units may be present in different subsets. The determination units are configured, each, to provide/determine/estimate/simulate an output value for one specific parameter. For example, there may be provided in the device a set of determination units which each are configured to output a value of the parameter temperature or a value of the parameter electrical current, or the like. Each subset is preferably connected/associated/linked to one target point of the machine which means that each subset provides/determines the value of one parameter for one target point. A target point most preferably is a spatial point, such as a point, an area or a specific volume part of the machine for which a value of the parameter shall be determined. The input data which is used by (based on which) the determination unit to determine the value of the parameter is dependent on the parameter and can be defined by a person skilled in the art based on the respective knowledge of the system/device, etc, where examples as to "temperature", "SOH" and "coolant" are discussed further below.

The term "set" and "sub-set/subset" shall herein refer to an assembly/combination/group of units. If the units are hardware-based, the sets may be hardware groups of the units, if the units are software-based, the groups are software modules/models grouping the software units. Of course, a mixed hardware-software type is also possible. If the units are software-based, the device may in general include mainly one or more processors and one or more storage devices where the storage devices store the software-based units, sets, subsets, etc.

For each parameter to be determined, preferably, one set of determination units is provided in the device and each determination unit preferably is configured to determine the value of one parameter. For example, if the parameters to be determined are temperature and electrical current, dedicated determination units and a set of these dedicated determination units are provided for the parameter temperature and dedicated determination units and a set of these dedicated determination units are provided for the parameter electrical current.

The device further may comprise an output interface for outputting a value determined by the subset(s). Of course, if there is more than one subset provided, more than one value can be determined and output. For example, if a plurality of target points are predefined/pre-set for a machine which shall be monitored or for which values of one or more parameters shall be determined, the respective number of subsets is provided in the device so that for each target point a specific subset is provided which can determine and output a value of a specific parameter. Here, often it is referred to an example of 54 target points of an e-motor. However, this is purely an example and of course any other number of target points may be used.

Therein, a specific type of the machine is not limited, and the machine preferably includes for instance a vehicle, an engine, an electric motor, a heat exchanger, any machine components, a machine tool and etc., wherein parts or components of the corresponding machine are monitored for obtaining corresponding parameters related to for instance those parts of components, so that preferably controlling of the machine is carried out on the basis of the obtained values of the parameters. Target point may preferably refer to predetermined spatial areas or points of said machine, whereas the values of the physical/control parameters of the target points may vary over time.

Therein, preferably the one or more sets of determination units (which may also be referred to as determination models) are stored in a storage unit of the device if the device is mainly software-based. Additionally or alternatively, the one or more sets of determination models are stored at a central storage unit provided by for instance a cloud service, such that the above device, at the time of determining values of parameters related to a machine, requests for and receives the one or more sets of determination models transmitted from the central storage unit. Of course, the manners of storing and for the device to obtain the one or more sets of determination models are not limited by the present disclosure and they are configured depending on the actual application scenario.

The device combines sets of determination units in subsets which are highly-specialized for outputting a specific value of a specific parameter of a specific target point, Thus, a more accurate and reliable measurement/determination of the values of the target points of the parameter is provided by applying/fusing determination units in the subsets. In particular, according to the present disclosure, it is ensured that for each target point, the best performing determination units are selected to be included (and fused, assembled, combined) in a subset, namely that the strengths of the units are exploited to the greatest extend. In the preferred example of this present disclosure, the machine is an electric motor and the parameters to be determined include temperature, SOH and/or, coolant temperature (or required cooling temperature) or flow rate of the coolant.

According to preferred aspects, each determination unit comprises a trained machine learning model/algorithm. Here, the meaning of machine learning (ML) model/algorithm/unit shall also include artificial intelligence (Al) model/algorithm/unit. The ML/AI being used as or within a determination unit have been preferably trained in advance so that they are configured to determine a specific value of a specific parameter. The degree of their training in advance is preferably set such that a measured reference value or the like can be reproduced within a certain confidence range, such as 15%, 10%, 5%, 1% or the like, compared to real measurement data or other benchmark data.

More preferably, each determination unit of one set comprises (or is) a different machine learning model/algorithm so that different ML/AI algorithms can be employed and fused/combined/assembled together.

Therein, different machine learning models are preferably different machine learning (ML) or artificial intelligence (Al) models, including for instance AdaBoostRegressor, LinearRegression, HistGradientBoostingRegressor, BayesianRidge and many others. Additionally or alternatively, the machine learning models preferably comprise one or more sub-combinations of a plurality of ML/AI models.

Using machine learning for determining the values and preferably using combined different machine learning algorithms, combined in a subset, can increase the accuracy of the determination greatly because the strengths of each model can be exploited best. Using ML/AI, in general, further improves that complex analytical models and the like do not need to be designed or provided. Further, the use of physical sensors can be reduced to a minimum.

For example, in the present disclosure and its (preferred) aspects, there is provided for instance M Sets of determination units or ML models, including Set 1 of determination units, Set 2 of determination units ... and Set M of determination units, wherein M is an integer and M ≥ 1. Among the M Sets, each Set m (m being an integer and 1 ≤ m ≤ M) is configured for estimating a/one corresponding parameter Pₘ (1 ≤ m ≤ M) related to the machine. In other words, there are a plurality of (e.g., physical or control) parameters, namely P₁, P₂ ... and P_{M} to be estimated for the machine. Therein, a parameter Pₘ is to be estimated by the Set m comprising a plurality of determination units.

More specifically, for the determination of the parameter Pₘ, the corresponding Set m comprises for instance Nm machine learning (ML) models, namely ML_{m,1,} ML_{m,2}, ..., MLₘ,_{Nm}, wherein Nm is an integer and Nm ≥ 1. That is, the Set m for determination of the parameter Pₘ comprises Nm machine learning models, wherein each model ML_{m,n} (n being an integer and 1 ≤ n ≤ Nm) provides an estimated/determined value of the corresponding parameter Pₘ.

As noted above, each machine learning model (or briefly "model") may be part of a determination unit or may be one determination unit itself as described above.

The number of determinations units in a set may depend on the corresponding parameter to be estimated. For instance, Set 1 comprises N1 units for estimating parameter P₁, whereas Set 2 comprises N2 units for estimating parameter P₂, wherein N1 is smaller than, equal to, or greater than N2. The values for N1, N2, etc. may be predefined or may be determined in a pre-selection process of determination units during the training of the ML models.

Therein, for the parameter Pₘ, preferably there are one or more target points (TP) thereof to be estimated. For instance, for a temperature parameter of an electric motor in a vehicle, there is preferably a large number of target points for the temperature parameter of the electric motor, namely a large number of locations inside and/or on the electric motor, the corresponding temperature of which should all be measured/estimated. In this example, target points of the temperature parameter comprise points spatially distributed over a part or the entire machine. Of course, this is not limited in the present disclosure. For instance, target points of a parameter preferably also comprise temporal points.

That is, for the parameter Pₘ, preferably a plurality of target points TP_{m,1,} TP_{m,2} **...** TP_{m,Lm} exist, wherein L is an integer and Lm ≥ 1. Among the Nm models/determination units for determination of the parameter Pₘ, each model ML_{m,n} provides estimated values for all of the L target points. That is, for instance, a model ML_{m,n}, comprised in the determination Set m for determination of the parameter Pₘ provides for the P target points, corresponding P determined/estimated values (briefly: EV), including EV_{m,n,1,} EV_{m,n,2,} ..., EV_{m,n,Lm}.

The number of target points of a parameter depends on the corresponding parameter to be estimated and the application scenario. For instance, for parameter P₁, L1 target points are to be estimated, whereas for parameter P₂, L2 target points are to be estimated, wherein L1 is smaller than, equal to, or greater than L2. Most preferably, the number of target points is set in advance by a human operator depending on the machine to be monitored and the desired accuracy of the monitoring.

Summarizing, for a parameter Pₘ, there is a plurality of target points TP_{m,l} (l being an integer and 1 < l ≤ Lm) to be estimated. Therein, for each target point TPₘ,ₗ, each model ML_{m,n} of the Set m can provide a corresponding determined value EV_{m,n,I}. As a result, one model ML_{m,n} provides, for the determination of the parameter Pₘ, Lm estimated values for all target points (TP_{m,1,} TP_{m,2} ... TP_{m,Lm}), namely EV_{m,n,1,} EV_{m,n,2,} ..., EV_{m,n,Lm}. Further, for one target point TP_{m,l} for the determination of parameter Pₘ, it is provided in total Nm estimated values by the Nm models ML_{m,1}, ML_{m,2}, ..., MLₘ,_{Nm} of the Set m since each model ML_{m,n} is to provide a corresponding estimated value EV_{m,n,l}.

According to the present disclosure, based on the Nm determined values EV_{m,1,l}, EV_{m,2,l} ... EV_{m,Nm,l} provided by models ML_{m,1}, ML_{m,2}, ..., MLₘ,_{Nm} for the determination of one target point TPₘ,ₗ associated with the parameter Pₘ, it may be selected a Subset m-l comprising one or more determination units/ML models selected from the Nm models.

As an example, the Subset m-l comprises the determination unit(s), selected from the Nm models comprised in the determination Set m, that provide(s) the most accurate determination for the target point TPₘ,ₗ.

Of course, the Subset m-l can include more than one determination unit selected from the Set m, which depends on the selection criterion for the target point TPₘ,ₗ. For instance, the selection criterion may be that the absolute errors of the estimated values provided by the selected models are not more than 10% in comparison with target value of the target point TPₘ,ₗ being estimated. Of course, selection criteria are not limited in the present disclosure. Preferably, the subset m-l for one target point TPₘ,ₗ comprises models that provide more accurate determinations compared with the remaining models that are not selected to be included in the subset m-l. The maximum number of determination units in one Subset may be pre-stored/pre-defined to reduce the complexity of a Subset. For example, it may be pre-defined that a Subset shall not include more than 3, 4, 5, 10 or the like determination units/models.

For a parameter Pₘ, there is one or more target points TP_{m,l}. Therein, preferably the constitution of each Subset m-l is different since each model performs differently for a target point TP_{m,l}. That is, a model may perform within an error margin for one target point, but may fail to meet an error margin for another target point, and therefore is selected to be included in a subset for merely the former target point. Hence, the number of models in a Subset m-l depends on how many models fulfil the error requirement. Therein, the error margin may comprise a pre-determined maximum absolute/rms (root mean square) error or the like. Of course, those examples are not to be construed to be limiting.

As a result, for the determination of the parameter Pₘ at the target point TP_{m,l}, a Subset m-l is provided according to the present disclosure, wherein less accurate models in the Set m in regard of a specific target point are disregarded and only models that are more accurate for a specific target point than the disregarded models are included in the Subeset m-l.

Consequently, a more accurate and reliable measurement/determination of the values of the target points of the parameter is provided by fusing different determination units/ML models in the above described subsets.

In particular, according to the present disclosure, it is ensured that for each target point, the best performing models are selected to be included (and fused, assembled, combined) in the subset, namely that the strengths of the models are exploited to the greatest extend.

In some preferred aspects, the device is further configured to input a value determined by a subset for a first time epoch (wherein "first" can also mean "previous" epoch or epochs) as (part of the) input data to said subset for determining a value for a second epoch that follows the first epoch (wherein "second" may mean "subsequent" to the "first"). That may mean that the output value may be output (to/via the output interface) and at the same time it may be branched and used as input to the same subset of determination units/ML models.

In other words, for each selected Subset m-l for providing an even further improved determination value of the parameter Pₘ at the target point TP_{m,l}, it may be provided in accordance with the present disclosure a loop back scheme. Hence, for each determination unit in the selected Subset_{m,l}, an estimated value provided at time t-1 is looped back to the input of the each determination unit, such that the each determination model comprised in the selected Subset_{m,l} provides a next determined value for the time t on the basis of the input data comprising the estimated value at the previous time t-1. Alternatively or additionally, the value at t-2, t-3, t-4 and/or the like may be used for the looping back.

Therein, selection of the length of an epoch (time period) as defined may be chosen to be any suitable length of the time period to be considered as an epoch. The epoch may also refer to a specific point in time.

Looping of results/output of a determination unit or subset thereof (for calculating a next temporal point) supports the accuracy of the output over time, leading to consistency of the output over time, which provides a better/more stable output behaviour. According to the present disclosure, looping back of the values in the previous time period as (part of the) input data for the determination of the next time period also improves robustness and reliability of the device for providing a more accurate value of the parameter to be estimated.

In some preferred aspects, for each target point of said one parameter to be determined by a subset: the subset comprises/is a combination of determination units that have been (automatedly) selected from the respective set of determination units and that provide determined values within an error margin.

In the selection of models from the Set m for providing determination of the parameter Pₘ, in order to provide a subset providing an improved determination, different criteria may be applied. The subset shall mean, as explained before, a "fused" or "assembled" combination of AI/ML models or determination units.

Preferably, for the determination of a parameter Pₘ using the corresponding Set m comprising Nm models (ML_{m,1}, ML_{m,2,} ... ML_{m,Nm}), the selection criterion is that models shall provide values within a (pre-determined) error margin (for a certain percentage of the time of observation are selected).

For instance, it can be selected the models that provide an error with absolute error for less than 10% (5% or 1% or the like) compared with the true values (e.g. known from measurements taken by physical sensors from a physical test stand of the machine or the like) of the corresponding parameter (for at least 90% of the time). Of course, this is just an example for explaining the selection criterion. Depending on the actual application and in particular the machine in question and the parameters thereof to be estimated, it is not limited by the present disclosure as to the configuration of the selection criteria for providing the subsets.

The selection of determination units from a set of determination units and the assembly/fusing of the selected determination units such as to form the subsets thereof may preferably be performed during a testing stage which preferably is performed after the training of the determination units/ML models. In other words, the subsets may be formed/assembled based on real measurement data of an experiment or the like wherein a test operator or a computer may select the best models for each subset depending on their error behaviour. For example, if a test operator performs this task, they may pick for each subset one or more determination units to be combined within a subset wherein the determination units are picked based on the selection criterion of which provides values which are closest to comparison (measurement) values. In doing so, they may pick all determination units which fulfil the respective error criterion or they may pick less, e.g. if a maximum number of determination units per subset is predefined for reducing complexity and the like. Preferably, a subset includes at least two different determination units and, correspondingly, at least two ML models, however a subset may also include only a single determination unit. This task of assembling the subsets may also be computerized so that a computer would perform the above described assembly based on pre-defined assembly rules, such as minimum and/or maximum number of determination units per subset, error criteria, etc.

As a result, it can be flexibly selected the best performing models/units comprised in the Set m for providing values for the parameter Pₘ at various target points, thereby providing improved efficiency and accuracy as well as reliability in determination of parameters related to the machine.

Indeed, the fusing of determination units into different subsets of combined determination units, each subset for a different target point, allows to provide highly exact values for each target point without the need of providing physical sensors at each target point or without the need of providing a dedicated analytical model for each target point which reduces complexity.

In some preferred aspects, a subset may be configured to: determine a combined value on the basis of values determined by the determination units of said subset, and output said combined value as determination result for the target point of said subset.

According to the present disclosure, based on the selected Subset m-l for the determination of the parameter Pₘ at the target point TP_{m,l}, a combined value on the basis of the determined values provided by the determination units in the selected Subset m-l is provided as a final result (again it is noted that the term determination may also be construed as estimated, simulated or the like).

The number of combined models/determination units for a subset may be 1 (no combination) or more. If for a specific spatial point e.g. three trained MLs/determination units fulfil the error requirements, the most preferred case would be to combine all three. However, of course e.g. only two of the three might be combined for the specific spatial point for certain reasons, e.g. the two have much higher accuracy than the third one. The combination of models may also be called "fusing" or "assembling", as already noted and explained above. Each ML model/determination model may be part of no, one or more subset.

As a result, the final result is provided on the basis of only the best performing machine learning models for the determination of the corresponding target point, whereas models that perform less accurately are not assembled in the respective subset. Further, the combination of the determination values provided by the subset ensures that best performing models all contribute to the final result which combines the strengths of the selected models. This leads to improved accuracy and reliability in the determination of the parameters for the machine.

In some preferred aspects, said combined value is determined by calculating an average value of determined values provided by each determinations unit of the corresponding subset.

According to the present disclosure, an average value of the estimated values provided by the determination models in the selected Subset m-l is provided as the final result of the corresponding parameter Pₘ at the target point TP_{m,l} for the machine. This can be calculated quickly and without high computational costs. However, instead of using an average, other possibilities exist, such as outputting only a single value which fulfils pre-defined criteria, such as outputting of the maximum or minimum value or the like.

In some preferred aspects said combined value is determined by calculating an weighted average value of the values provided by the determinations units of the selected subset. For instance, a higher weight may be attributed to higher accuracy models for a target point TP_{m,l}.

In both of the above-mentioned manners for calculating the final result, less accurate results possibly still existing in the selected subset can be evened out, thereby leading to furthermore improved accuracy and reliability of the determination of the parameters for the machine.

Furthermore, an aspect of the present disclosure may relate to a system including at least two devices according to at least one of the above described aspects. Preferably, the system may include at least one of the devices being configured to determine values of physical parameters of the machine and input the determined values into another of the devices as (part of) input data. Further, the other device may be configured to determine values of one or more control parameters of the machine and output them to an external entity as control signals or the like. In this connection, one could also say that the device which outputs values for physical parameters or the like is a virtual sensor or a virtual measurement device, and that the other device which outputs control parameter values is a virtual control device (which may include a virtual sensor device).

A configuration as described above may include the following features, for example: a first plurality of sets of physical parameter determination units for estimating a plurality of physical parameters related to said machine, and one or more physical parameter determination subsets for providing determination values for target points of one physical parameter to be estimated by said each subset of physical parameter determination units, and a second plurality of sets of control parameter determination units for determining a plurality of control parameters related to said machine, and one or more control parameter determination subsets for providing determination values for a/one control parameter to be estimated by said each subset of control parameter determination units. In regard of the control parameters, it is possible to have a plurality of subsets for a plurality of control target points, however, it may also well be that the output of the "control parameter device" is a global control parameter value. For example, it may be that a plurality of target points is monitored with the physical parameter device ("virtual sensor") and that the so "measured" values are input into the other, i.e. the control parameter device ("virtual controller"), which then uses the plurality of "measured values to output a (single) control parameter value (per unit time). More concretely, if an electric motor of an electric vehicle is analysed in regard of the temperature at different spatial points of the electric motor by the "virtual temperature sensor", these temperature values may then be input into a "virtual cooling control device" which uses, inter alia, the input temperature values as data for determining a control value, such as cooling. Cooling as a control goal may be that the virtual cooling control device outputs an estimated optimal cooling temperature for a point A (this output can be multiplied for multiple points). In this way, the system can then be triggered (by external control, for example, using a thermal management control device) to achieve this optimal cooling temperature for point A and/or other points of the electric motor. Alternatively, the cooling as control goal may include that the controller outputs the determined optimal coolant flow rate to ensure optimal cooling of point A (or others).

In other words, in connection with the above example, the M parameters Pₘ to be estimated by the device preferably comprise a first plurality of physical parameters as well as a second plurality of control parameters. As an example, for a vehicle, the M parameters preferably comprise a first plurality of physical parameters including for instance temperature (at a plurality of different target points), coolant (oil) flow rate at rotor, motor revolution, voltage (at various target points) and etc., wherein the parameters further comprise a second plurality of control parameters including for instance a cooling value such as explained above.

According to the present disclosure, preferably the determination of the second plurality of control parameters are provided on the basis of the determination of the first plurality of physical parameters. Still using the example of the machine being an electric motor, a determination of the cooling value (such as coolant flow rate or cooling temperature target for an external thermal management device) is preferably determined on the basis of for instance determination of temperature parameters and SOH of the electric motor.

Therein, for each of the physical parameters and for each of the control parameters, there preferably likewise exist one or more target points. The determination for one parameter, being a physical parameter or a control parameter, is discussed above, to which reference is made.

For instance, for one physical parameter Pₘ₁ (m1 being an integer and m1 ≥ 1) among all of the physical parameters, it is provided Subset m1-l1 for target point TP_{m1,l1}, Subset m1-l2 for target point TP_{m1,l2} ... Subset m1-IX for target point TP_{m1,lX}, wherein IX is an integer and IX ≥ 1. Thus, Subset m1-l1 provides for the target point TP_{m1,l1} determined values (possibly combined into a result as discussed above) given by the determination units comprised in the Subset m1-l1, and analogously Subset m1-l2 provides for the target point TP_{m1,l2} values (possibly combined into a result as discussed above) given by the determination units comprised in the Subset m1-l2 ... and Subset m1-IX provides for the target point TP_{m1,lX} values (possibly combined into a result as discussed above) given by the determination units comprised in the Subset m1-lX. Of course, the number of target points for the determination of the physical parameter Pₘ₁ is not limited and depends on e.g., the specific physical parameter to be estimated.

That is, estimated values for one or more target points of at least one of the second plurality of physical parameters are provided as input data for providing values for the control parameters.

As an example, for physical parameters including for instance Pₘ₁ and Pₘ₂, there are provided respective physical parameter determination subsets for target points for Pₘ₁ and physical parameter determination subsets for target points for Pₘ₂. Analogously, for a control parameter Pₘ₃ at a target point, there is a provided control parameter determination subset. The values (possibly combined into a result as discussed above) provided by the physical parameter determination subsets for the determination of Pₘ₁ and Pₘ₂ are input to the control parameter determination subset for providing values (possibly to be combined into an estimated result as discussed above). Of course, this is merely an example, to which the present disclosure is not limited.

Additionally or alternatively, according to the present disclosure, a control parameter determination subset receives as input data values (possibly combined into determined results as discussed above) from one or more of the other control parameter determination subsets.

Therefore, determined values provided by the physical parameter determination subsets (additionally or alternatively, by other control parameter determination subsets) are provided as input data for a control parameters subset, such that determination of control parameters is carried out on the basis of accurate results provided by subsets comprising selected models that perform in compliance with the error margin for a corresponding target point.

As a result, accuracy and reliability in providing of the control parameters for functioning of the machine can be furthermore improved. Moreover, a "virtual control device" can be thus provided which does not require complex hardware installations, especially sensors, and which could be even realized (at least mainly) by software. More concretely and preferably, a (virtual) cooling control device of an electric motor can be provided which operates based on the input of the temperature of an electric motor determined for various points of the electric motor by the first device according to this disclosure (a virtual temperature detection device/sensor).

A further aspect may comprise a method for assembling a device or system according to at least one of the aspects described above, including the steps of:
- providing for each parameter of a machine a set of determination units (3) each including a machine learning model,
   - assembling for each target point of each parameter of the machine a subset of determination units by selecting one or more determination units of the set of determination units, wherein the selection of determination units is performed by comparing values determined by the determination units for the parameter and for the target point with measurement data of said parameter and said target point and wherein one or more determination units are selected if the determined value of a determination unit is within a predefined error margin compared to the measurement data. Alternatively or additionally, high performing models could be used as criteria, in case, e.g., no other model meets the pre-defined criteria, such as error margin which can ensure that each target point has at least one determination unit/ML model. In this regard, high performing may mean that the (next) best performing model(s) may be used, if, e.g., the error margin criteria are not met for a target point.

In other words, the aspect of the assembling method reflects the above described processes of defining the sets of determination units, which may mainly include picking the most suitable machine learning models for a specific parameter, e.g. based on error criteria met by the models during or after their training or based on the experience of a skilled person performing this step, and assembling/combining for each target point and for each parameter the determination units included in the respective set of a parameter to form subsets, wherein each subset is associated with the target point and the parameter for which it has been formed. Each ML model/determination unit may appear in zero, one or more subsets. The selection, as described above, is performed based on, e.g. and in particular, error criteria and may be automized. The assembling of subsets is preferably performed after an (initial) training of each ML model so that sufficiently stable output values can be expected for each ML model.

After the assembly of the subsets, the device is ready for real-time use and includes the assembled subsets of trained ML models and can be fed with input data to determine the values of pre-defined parameters of a machine as output of said device. In other words, among others, the combination of suitable trained ML models in subsets allows to achieve the above described technical advantages. Further, if a loop back process is further introduced for each subset and/or for each determination unit of each subset, the stability and accuracy of the output results can be further improved.

In a further preferred aspect, the method may include the step: the machine learning models are trained by inputting training data before providing them into a set of determination units, wherein determination units are provided into a set if the included machine learning model is able to reproduce measurement data of a parameter of a machine within a pre-defined error margin. As noted above, assembling the set of determination units may also be performed based on error criteria and/or experience of the skilled person. This step may reduce the number of available ML models in a set so that the step of building subsets is less complex and so the assembly of the device may be performed faster.

A further aspect of the present disclosure may also include a computer program comprising instructions which, when the program is executed by a computer or processor, cause the computer to act as the device according to at least one of the device aspects explained above. In other words, the device as described above may be configured based on software.

It is again noted that, preferably, the input data of the device (at least during a testing and training phase) may also comprise ground truth data, that is, measurement data/experimental data or the like of the machine with which the error margin of each trained model is calculated. Further, preferably the input data may comprise modified/derived/engineered machine data which may be provided based on the original machine data using for instance physical relationship between the values of the parameters provided in the machine data as well as domain knowledge. As an example, modified machine data may comprise data related to functioning of an electric motor by multiplying current I and voltage V (power as an "engineered value" derived from two measurement values).

As noted above, the machine may be an electric motor, wherein said parameters related to said electric motor comprise the temperature inside a motor of the vehicle preferably at different positions, SOH of the electric motor and/or, coolant temperature and/or flow rate.

Summarizing, a solution is provided which offers technical benefits especially with regard to the accuracy and reliability and complexity in determination of parameters related to a machine and in providing improved control. In particular, it may be provided in accordance with the present disclosure a virtual sensor device for providing values of the parameters. The device comprises, for each parameter to be estimated, (preferably pre-selected) and/or (preferably trained) determination units configured in a set, wherein the device further comprises a subset including models selected from the set, the selected models are those the error of which for a target point lies within, e.g., a pre-determined error margin or other pre-defined selection criteria. The device preferably further comprises combined selected models of the subset, the combined models are combined in a sense that their estimated values for the parameter (at the corresponding target point) are combined for instance by a weighted average to provide a final estimated result for the parameter (at the corresponding target point).

The device according to the present disclosure preferably may form or include more than one virtual sensor. For each "sensor" a subset of MLs is selected, preferably after the training, based on error requirements for instance as mentioned above. Further, values of sensor(s) are fed to a virtual determination part (e.g., a cooling controller for the electric motor) which uses the output of the sensors to determine a control value. As an example, virtual sensors provide "SOH of the electric motor" and "temperature" to a determination part and the determination part determines "cooling values" as control output. Other parameters may be selected depending on the type of the machine or sub-part thereof.

It can be summarized in other words, that the solution provided in the present disclosure may comprise at least one of the following steps:
i) Training of multiple AI/ML methods,
ii) (Automatically) determine the best set AI/ML method(s) for a given target point,
iii) Fusing of the AI/ML model sets, and
iv) Using feedback methods
to produce a robust and highly accurate output.

The technical benefits lie in that, inter alia, the device can use the selected models performing in compliance with the error requirements for determination of the parameter (at the corresponding target point), wherein in particular, for any target point, the subset comprises only the best performing models, with the less accurate models being disregarded for the specific target point. Therefore, the determination for all target points is ensured to be the most accurate.

### Brief description of the drawings

In the following the claimed subject matter will be further explained based on at least one preferential example with reference to the attached drawings, wherein:
- Figure 1: shows a configuration of a plurality of sets for determining values of a plurality of parameters related to a machine in accordance with the present disclosure.
- Figure 2: shows a configuration of a machine learning model/determination unit of Fig.1, for providing determined values for a parameter at a plurality of target points related to a machine in accordance with the present disclosure.
- Figure 3: shows a configuration of a subset of machine learning models selected from models of Fig.1, for estimating one parameter at a target point related to a machine in accordance with the present disclosure.
- Figure 4: shows a configuration of a feed-back loop of a determined value in accordance with the present disclosure.
- Figure 5: shows a configuration of a determination unit comprising models of Fig.1 providing determination with input from a sensor unit comprising models of Fig.1 according to the present disclosure.
- Figure 5a: shows a preferred specific example of a configuration of a device in accordance with the present disclosure.
- Figure 6: explains the assembling of a device in accordance with the present disclosure.
- Figure 7: explains the assembling of a preferred system in accordance with the present disclosure.

### Detailed description of the drawings

In the following, an example of the machine being an electric motor (or e-motor or motor) is introduced for explanation purposes. It is noted that this example is in no way to be construed as limiting the applicability of the present disclosure on other machines. The machine may well be a stationary machine instead of a vehicle or a sub-component of the vehicle. The vehicle may be a car, a truck, a train, and the like.

One of the complex factors in connection with the determination of the state of a machine and/or its control is the temperature of an e-motor especially at different points thereof. Understanding the temperature of the electric motor, especially at different positions/points thereof, helps to improve thermal management control of the electric motor. Robust thermal management allows to elevate the rated power level (cost/material reduction) for e-motors. Sensor-based temperature monitoring in electric machines is limited due to costs and integration efforts as well as physical space for installing many physical temperature sensors or the like at different locations.

Without accurate means of determining or modelling complex factors, such as the temperature, it would be very difficult to improve a robust thermal management control for e-motors or other devices. Again, as noted before, instead of the machines as described above and in the following other machines may be subject of the herein described solution, e.g. a heat exchanger may be determined in regard of flow patterns, a semiconductor might be analysed in regard of electrical parameters and/or temperature and so on.

The present disclosure provides a robust, efficient, and accurate method to determine a parameter related to a machine and more specifically at different target points, and more preferably the temperature at various points inside an electric motor. Further, the present disclosure provides a robust, efficient, and accurate device for determining a control parameter for controlling, e.g., the electric motor in view of its thermal management. In other words, the present disclosure can provide a "virtual" sensor and one or more of these virtual sensors may output the determined values to a "virtual" controller which then outputs, based on the input, control values.

As an example, experiments show that the temperature of an operating e-motor of an electric vehicle is not uniformly distributed around the e-motor. In a test stand and/or a computer simulation for verifying the present solution, e.g., physical sensors mounted at for instance 54 different points of the motor showed 54 different temperature measurement values. Such complexity makes it difficult to be captured by an analytical model for describing said complex temperature behaviour. Having this in mind, the complexity or high-dimensional nature of functioning of the machine (e.g., the heating of e-motors, fluid flow in tubes, heat exchangers, electrical currents in transistors, or the like) is captured by the present disclosure by employing a solution driven by artificial intelligence (Al)/machine learning (ML) combined with mathematical modelling. In other words, the present solution has been found by addressing the following points during the research of the inventors for providing a virtual sensor and a virtual controller: solution design, experimental design and data collection, training several AI/ML models to capture the complexity of the target system, and automatic fusion and selection of AI/ML to increase model robustness and accuracy. In this way, by way of one example, the powertrain (e-motor and inverter) of an electric vehicle can be assessed in regard of the temperature and in view of improving the control of the temperature or enabling an improved control of the temperature of the electric motor.

Summarizing, the present disclosure provides a robust and accurate method/device for estimating physical and/or control parameters related to a machine.

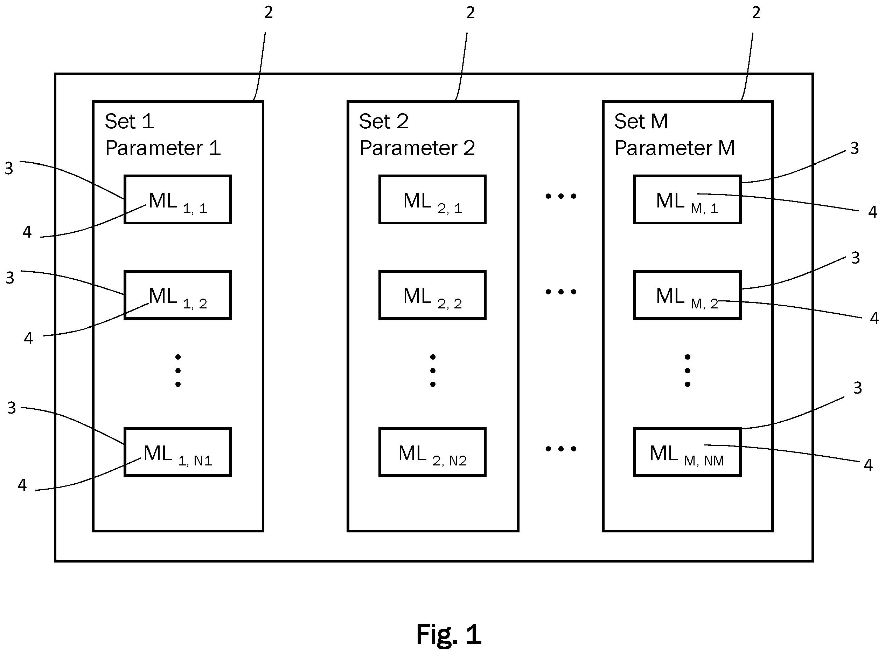

Fig.1 shows an example for a part of the claimed device in which the determination units 3 with the respective sets 2 thereof are depicted. The machine learning models included in each determination unit 3 (or being part of them) are marked by reference sign 4 (in the middle set 2 the reference signs are not provided for reasons of readability of the Figure).

As shown in Fig.1, there is provided in the device 1 in accordance with the present disclosure, M sets 2 of determination units 3, namely Set 1, Set 2 ... Set M, wherein M is an integer and M ≥ 1, and represents the number of parameters to be estimated for the machine. Therein, with a Set m (m being an integer and 1 ≤ m ≤ M), a corresponding parameter Pₘ is to be determined. Accordingly, with the M sets 2 it is to be determined M parameters related to the machine. The determination units 3 include or are ML/AI models/units 4.

Therein, with any Set m for the determination of a corresponding parameter Pₘ, there is provided a plurality of machine learning models ML (also referred to as units) 4, namely ML_{m,1}, ML_{m,2}, ..., ML_{m,Nm}, wherein Nm is an integer and represents the number of models in the corresponding Set m. That is, for the determination of a parameter Pₘ, the device comprise a Set m comprising Nm machine learning models 4, wherein Nm ≥ 1 and Nm possibly different for each set 2.

Of course, the specific number of determination units 3 comprised in each set 2 for the determination of a corresponding parameter is defined depending on the specific application scenario as well as the specific parameter that is to be estimated by the corresponding set.

Preferably, for the determination of a parameter using the corresponding set, the Nm machine learning models 4 comprised in the set are trained, more preferably with different objective functions. Therein, preferably, the training data comprises machine data including for instance relevant physical parameters, geometry and etc. of the physical model related to the machine (e.g., experimentally gained measurements of temperature at different spatial points of a certain component of the machine). Preferably, the training data comprise modified/derived/engineered machine data which are provided on the basis of the original machine data using physical relationship and domain knowledge. For instance, in an example where the machine is an electric motor, the current and voltage values obtained as the machine data are modified to obtain a further parameter by multiplying the corresponding current and voltage values, i.e. power as derived/engineered data. Further, the training data preferably comprise target values of the to-be-estimated parameters related to the machine, such as the electric motor.

For instance, for the Set m for the determination of the parameter Pₘ comprising Nm machine learning models 4, all of the Nm machine learning models are trained on the basis of the training data comprising at least one of the above-mentioned machine data, engineered (derived) machine data and target values for the parameter Pₘ, such that the Nm machine learning models are provided in the device 1 (in the determination units 3) as trained models for accurate determination of the parameter Pₘ.

Therefore, it is provided in the device in accordance with the present disclosure a plurality of sets 2 for the determination of a corresponding plurality of parameters related to the machine, each set 2 being provided with one or more determination units 3 including and/or being machine learning models 4 which have been trained specifically for the determination of a corresponding parameter.

Further, since for each set 2, the machine learning models 4 may be trained with different objective functions, machine learning models 4 with different characteristics in estimating the parameter are provided, so as to provide improved reliability and accuracy of the determination.

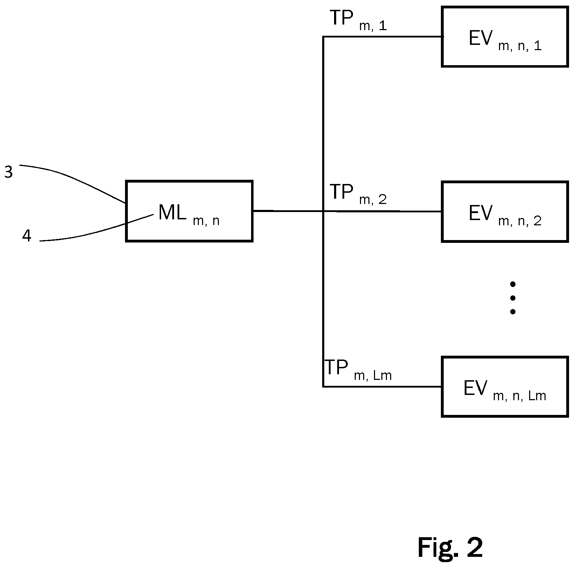

Fig.2 provides an example which shows one determination unit 3 of the sets 2 as shown in Fig.1, for providing for different target points TP_{m,1..LM} a determined value EV.

As illustrated in Fig.2, there is provided in the device a machine learning model ML_{m,n} 4 (as a determination unit 3 or within a determination unit 3) which is configured in the corresponding Set m for the determination of the parameter Pₘ as shown in Fig.1, wherein m is an integer and 1 ≤ m ≤ M, M representing the number of parameters to be estimated, and n is an integer and 1 ≤ n ≤ Nm, Nm representing the number of units in the Set m.

According to the present disclosure, the parameter Pₘ is to be estimated by each machine learning unit 4 in the Set m at one or more target points. That is, for any machine learning model ML_{m,n} 4 comprised in the Set m for the determination of the parameter Pₘ, a plurality of estimated values (EV), EV_{m,n,1}, EV_{m,n,2} ... EV_{m,n,Lm}, are provided for the Lm Target Points, namely TP_{m,1}, TP_{m,2}, ... TP_{m,Lm}, wherein Lm is an integer and Lm ≥ 1, and represents the number of target points to be estimated for the parameter Pₘ.

Hence, according to the present disclosure, in the Setₘ for the determination of the parameter Pₘ, each of the machine learning models 4 in the Setₘ is in principal enabled to provide values for all target points of the parameter Pₘ.

As a result, each of the machine learning models 4 comprised in the Setₘ for the determination of the parameter Pₘ could be applied to each of the target points related to the parameter Pₘ, wherein for instance a machine learning model ML_{m,n} may perform more accurate for one target point and perform less accurate for another target point. That is, the characteristics of each machine learning model 4 in the determination of each target point can be captured and tested with the configuration provided in the device 1 in accordance with the present disclosure.

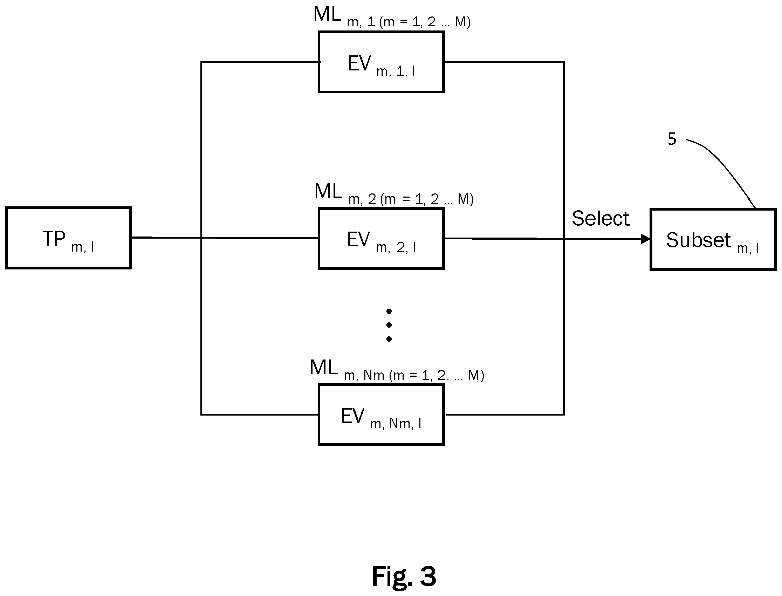

This thus provides basis for providing improved determination of the parameters since the strength and weakness of each machine learning model 4 at each target point related to a parameter can be provided in the device 1 and applied such that for instance for a target point, only the machine learning models 4 that perform well are used in the determination. In other words, subsets 5 of the most suitable machine learning models 4 (or their related determination units 3; please see Fig. 3) can be assembled and are assembled within the herein disclosed device 1 which have proven during tests to provide the most accurate results for a specific target point or more. In even other words, sub-combinations of a set 2 of determination units 3/ML models 4 are provided in the device 1 which deliver the most accurate output results (determined values) for a target point.

Fig.3 provides a configuration of the device 1 in accordance with the present disclosure, the device 1 comprising the before mentioned subsets 5 comprising determination units 3 /ML models 4 selected from the sets 2 shown in Fig.1 based on the values as provided in accordance with Fig.2.

As illustrated in Fig.3, for any target point TP_{m,l} (for the determination of parameter Pₘ at target point TPₗ, wherein I is an integer and 1 ≤ l ≤ Lm), the determined values provided by the Nm machine learning models 4 in the Set m are provided as a basis for selecting therefrom the machine learning models 4 that perform well, e.g., within a predefined error range.

That is, the Nm machine leaning models 4 in the Set m are examined on the basis of their correspondingly provided determined values, including EV_{m,1,l}, EV_{m,2,l}, ..., EV_{m,Nm,l} for the target point TP_{m,l}, such that from the Nm machine learning models 4, it can be selected therefrom one or more machine learning models 4 forming a Subset_{m,l} 5 for the determination of parameter Pₘ at the target point TP_{m,l}. More specifically, the determination units 3 with a machine learning model 4 (or a combination of machine learning models) therein are selected.

The selection can be based on different criteria including for instance comparing the determined values with ground truth data (e.g., measurement data/experimental data or the like of the corresponding parameter at the relevant target point), and selecting only the machine learning models 4 that provide a satisfactory performance, for instance, within a predetermined error margin for this relevant target point.

Of course, any possible selection criterion may be applied depending on the specific application scenario, for instance there may be cases where merely one machine learning model 4 can be selected, as well as up to that all of the machine learning models 4 can be selected.

According to the present disclosure, the determined values provided by machine learning models 4 comprised in a set 2 for the determination of the corresponding parameter at a target point are compared with ground truth data representing measured values or experimental values of the parameter at this target point, such that only the machine learning models 4 that perform well for this target point for the parameter are selected for forming a subset 5 for the determination. It is to be noted that preferably the selection and subset assembly is performed after the machine learning models 4 have been trained, at least to a predetermined degree of training level.

As a result, machine learning models 4 that do not perform well are disregarded when assembling subsets 5 of the device 1 for a specific task, thereby improving the accuracy and reliability provided by the assembled subset 5. Further, the configuration of the subset 5 in the device 1 is flexible and can be efficiently obtained, changed or updated depending on the target point in question. Such a configuration of the subsets 5 in the device as provided by the present disclosure ensures a quick response to the determination requests of versatile parameters at various target points. Each determination unit 3 or included ML model 4 may be included in zero, one or more subsets 5.

Preferably, the determined values provided by the selected machine learning models 4 comprised in the subset 5 may be combined in different manners for providing a final result. It may be that the determined values provided by the machine learning models (determination unit) in the selected subset 5 are combined by using an average value thereof. It may also be that the determined values are combined using weighted average, wherein for instance more accurate models are attributed a higher weight. Of course, the combination of the determined values of the machine learning models 4 in the selected subset 5 depend on the application scenario and/or the experience of the skilled person.

According to this disclosure, the performing characteristics of each machine learning model 4 in a set 2 for the determination of a corresponding parameter can be evaluated for a certain target point, and only machine learning models 4 are selected that perform well as expected in comparison with the ground truth data. Accordingly, the selected machine learning models 4 can be applied in the determination of the parameter with improved accuracy and reliability.

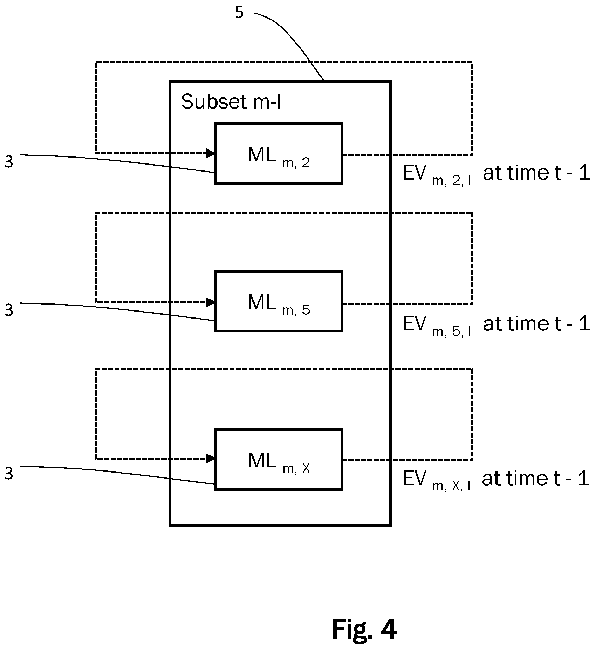

Fig.4 provides an example configuration of the device 1 comprising a subset 5 provided in accordance with Fig.3, wherein determined values provided by the determination units 3 in the subsets 5 at a previous time period/epoch t-1 are input to the same determination units 3 for providing estimated values for the next time period/epoch t.

That is, it is preferably provided in accordance with the present disclosure, a loop back scheme/ feedback loop for the subsets 5.

As an example merely for explanation purposes, it is illustrated in Fig.4 a Subset m-l 5 for the determination of the target point TP_{m,l} for the parameter Pₘ, which is provided in accordance with Fig. 3. Suppose that there are selected from the Set m, the following three machine learning models/determination units 3, namely, ML_{m,2}, ML_{m,5} and ML_{m,X}, for each of the selected machine learning models 4, the corresponding determined values EV_{m,2,l}, EV_{m,5,l} and EV_{m,X,l} provided at epoch t-1 are fed back to the input, such that determined values at the next epoch T are provided on the basis of the feedback data at the previous epoch t-1. As noted before, the values can also be taken from t-2, t-3, and/or the like.

As a result, the subset 5 comprising the selected machine learning models 4 in the device 1 according to the present disclosure are configured to be self-adapting using the estimated values provided at previous time periods for improving accuracy and reliability of the estimated values provided at the next period.

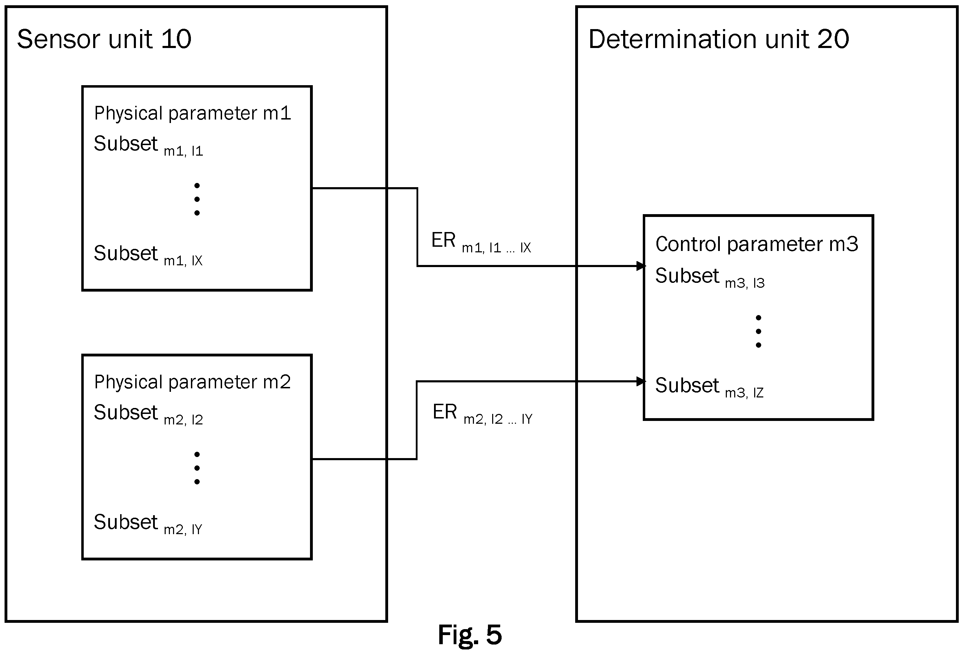

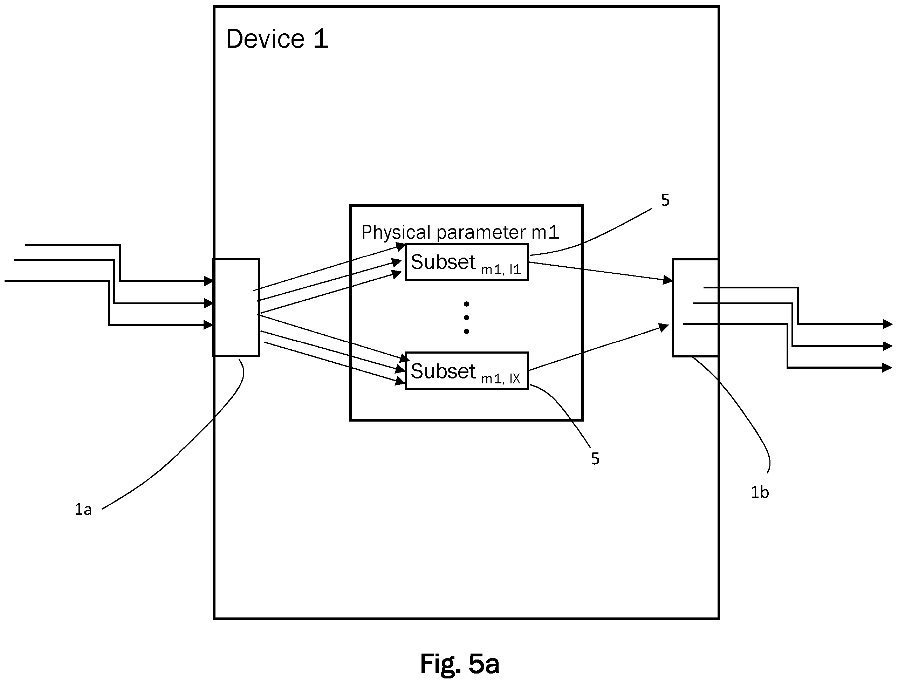

Fig.5 provides an example configuration in accordance with the present disclosure, where a system comprises two devices 1 in accordance with the present disclosure (the number of devices 1 is arbitrarily selected for explaining the working principle without limiting the number and the number of devices 1 may be also three, four, ten or the like). One of the devices 1 is configured such as to mimic a sensor unit 10 ("virtual sensor") while the other device mimics a "controller", being referred to as determination unit 20 or control unit. The sensor unit 10 and the determination unit 20 are included in the system for providing determinations for physical parameters and control parameters related to the machine.

The above-described principles and examples as illustrated in Figs.1-4 apply to both the physical parameters and the control parameters mentioned here for Fig.5. It is noted that the physical parameters and corresponding subsets, as well as the control parameters and corresponding subsets as shown in Fig.5 are merely for explanation purposes, and shall not be construed to be limiting.

According to the present disclosure, the system comprises the sensor unit 10 and the determination unit 20 as shown in Fig.5, wherein the sensor unit 10 comprises a plurality of subsets 5 for the determination of a corresponding plurality of parameters and the determination unit 20 comprises a plurality of subsets 5 for the determination of a corresponding plurality of parameters. The parameters to be estimated by the sensor unit 10 and to be estimated by the determination unit 20 are preferably different. For instance, the sensor unit 10 is configured to provide determined values for a first plurality of physical parameters and the determination unit 20 is configured to provide determined values for a second plurality of control parameters. Of course, the sensor unit 10 and the determination unit 20 may also be configured to provide estimated values for both physical parameters and control parameters.

Further, the determined values for parameters at various target points, as provided by subsets 5 comprised in the sensor unit 10 are provided as (or part of the) input data to subsets comprised in the determination unit 20. For instance, determined values of physical parameters as provided by the sensor unit 10 are input into the determination unit 20 for providing determined values for control parameters. Of course, this is not to be construed as limiting. For instance, the sensor unit 10 may also comprise subsets 5 for providing determined values for control parameters, which are input into the determination unit 20 for providing determined values for other control parameters.

Further, according to the present disclosure, the determined values provided by subsets 5 in the sensor unit 10 may be combined so as to provide combined determined results for parameters to be determined by the sensor unit 10. More specifically, for a subset 5 in the sensor unit 10, the determined values provided by the models 4 in this subset 5 are combined to provide a determined result for the corresponding parameter at the corresponding target point.

Therefore, determination of parameters by the determination unit 20 can be provided on the basis of accurate determined results provided by the sensor unit 10. In particular, for determination of control parameters by the determination unit 20 for providing accurate controlling of the machine, accuracy and reliability are improved.

In the example of Fig.5, for the determination of a physical parameter Pₘ₁, there may be selected, respectively for target points TP_{m1,l1} ... TP_{m1,lX}, the following subsets 5, namely Subset_{m1,l1} ... Subset_{m1, lX}. Therein, 11... IX are integers preferably arranged in an ascending order and 1 ≤ l1 ... lX ≤ Lm1, wherein Lm1 represents the number of target points for the parameter Pₘ₁.

Similarly, for the determination of a physical parameter Pₘ₂, there may be selected, respectively for target points TP_{m2,l2} ... TP_{m1,lY}, the following subsets 5, namely Subset_{m2,l2} ... Subset_{m1, lY}. Therein, l2 ... lY are integers and 1 ≤ l1 ... lY ≤ Lm2, wherein Lm2 represents the number of target points for the parameter Pₘ₂.

The configuration of subsets 5 are provided in accordance with Fig.1-3, to which reference is made. In particular, each subset 5 may be assembled such as to include a selection of ML models 4 from a set 2 for a respective parameter.

Accordingly, Subset_{m1,l1} ... Subset_{m1, lX} respectively provide estimated values of target points TP_{m1,l1} ... TP_{m1,lX}, wherein preferably these estimated values are further combined to form corresponding determined results (ER) for the target points TP_{m1,l1} ... TP_{m1,lX}, namely ER_{m1,l1...lX}.

Similarly, Subset_{m2,l2} ... Subset_{m2, lY} respectively provide determined values of target points TP_{m2,l2} ... TP_{m2,lY}, wherein preferably these determined values are further combined to form corresponding determined results (ER) for the target points TP_{m2,l2} ... TP_{m2,lX}, namely ER_{m2,l2...lZ}.

According to the example provided in Fig.5, the determined result provided by the physical parameter subsets 5, namely ER_{m1,l1...lX} and ER_{m2,l2...lZ}, are provided as part of the input data to the control parameter subsets 5 for determining the control parameter Pₘ₃ at target points TP_{m3,l3} ... TP_{m3,lZ} with the following subsets, namely Subset_{m3,l3} ... Subset_{m3, lZ} wherein l3 ... lZ are integers and 1 ≤ l1 ... lZ ≤ Lm3, and Lm3 represents the number of target points for the control parameter Pₘ₂.

Of course, one or more of the results provided by the sensor unit 10 may be provided to one or more subsets 5 in the determination unit 20. Further, the determination unit 20 may also only include a single subset 5 for determining a control parameter if the control parameter is a globally valid value, such as an electric current to be fed to an electric motor or the like, and the single subset 5 may receive determined physical parameter values from one or a plurality of subsets 5 of sensor unit(s) 10.

Thereby, according to this disclosure, accuracy and reliability in the determination of the control parameters for providing controlling of the machine can be improved since first of all, for all of the physical parameters and control parameters, the above-described selection, and/or combination and/or feedback scheme may be applied, and further to that, the results provided by the physical parameter subsets 5 using the aforementioned schemes may be further provided as input data for the determination of the control parameters, such that the control parameters are estimated on the basis of input data that are already with improved accuracy and reliability. As a result, with the control parameter subsets 5 further applying the above schemes, together with the accurate input data provided by the physical parameter subsets, accuracy in the determination of the control parameters can be even further improved. In other words, a system can be provided with reliable and accurate virtual sensor and virtual control devices.

Further Figure 5a shows, as a further example, an overall configuration of a device 1 as disclosed herein. The device 1 is shown schematically and only parts relevant for the explanation of the following aspects are depicted. Three arrows are shown in Figure 5a to point to a component of the device 1 which is an input part or input interface 1a. The number of arrows is not relevant and merely indicates that a number of different data sets may be input into the input interface 1a. From the input interface 1a, the input data (during the operation they may include, for the temperature determination and/or the SOH of an electric motor, the ambient temperature of the electric motor and the operation condition of the electric motor) is then internally distributed, as shown by further arrows, to the subsets 5, wherein in the present example it is assumed for the sake of simplifying the drawing, that only a single parameter m1 is to be determined, e.g. one of temperature, pressure, electrical current or the like. The number of subsets 5 is not further specified in the drawing and may preferably depend on (be equal to) the number of target points which shall be monitored/for which values shall be determined. The internal configuration of the subsets 5 has been explained above. The values determined by the subsets 5 are then output and sent to the output interface 1b as also schematically shown from which output data (shown by further arrows) are provided to another entity or to the external. Again it is noted that the Fig.5a shows a relatively simple configuration which can be further extended based on which has been described before, e.g., by adding further parameters to be determined, by adding further devices 1 (such as to form a system as described, e.g., in connection with Fig.5) and the like.

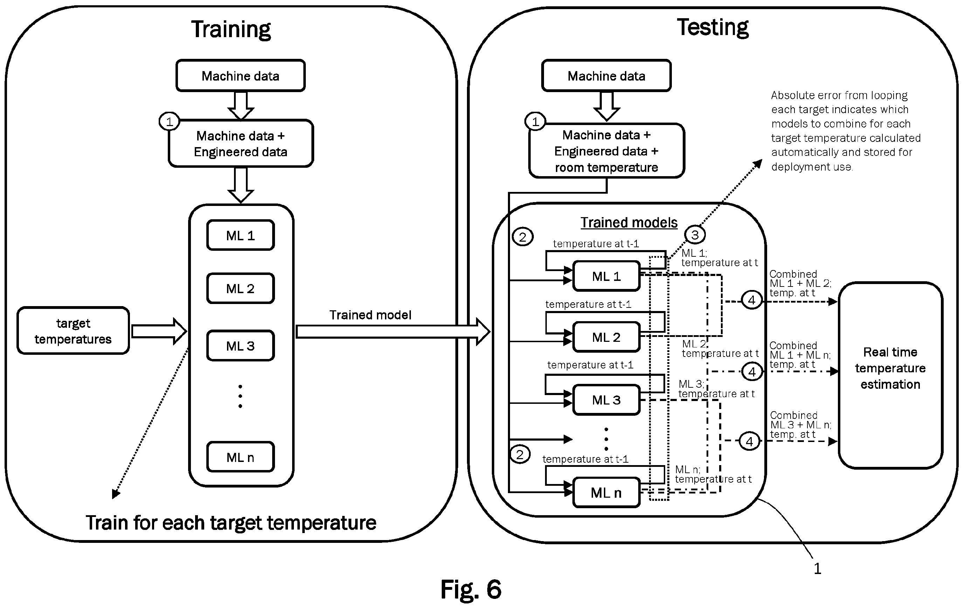

Figure 6 shows an overview over a procedure to assemble a device 1 in accordance with the present disclosure. In this connection the above mentioned example of a temperature distribution in a part of an (or an entire) electric motor is used to explain the principal steps, whereas the application scenario of using the present disclosure for determining the temperature of an electric motor preferably at different positions of the electric motor is one of the most preferred application scenarios.

Firstly, as shown on the left side of the Figure, training of sets 2 of determination units 3 with machine learning models ML 1 to MLn 4 is performed. For the training, machine data and engineered data is provided to the set 2 (in the present example, for the sake of simplicity, a single set 2 is shown which may however be more than one set if more than one parameter shall be determined). Further, for training the models 4, target temperatures are input as shown in connection with step "1" in the left-side box. Thereby, the models 4 in the determination units 3 are all trained for the target temperatures.

During data engineering, new features are created from the original machine data using physical relationship and domain knowledge. For example, a feature called "I_V" is generated by multiplying current I and Voltage V, and a feature "time_since_motor_operation_current_cycle" is created by calculating the time since the start of the motor in the current cycle, and the feature "last_down_time" is created by calculating the time between the end of last cycle and the start of the current cycle. Such data are used for the training as described above.

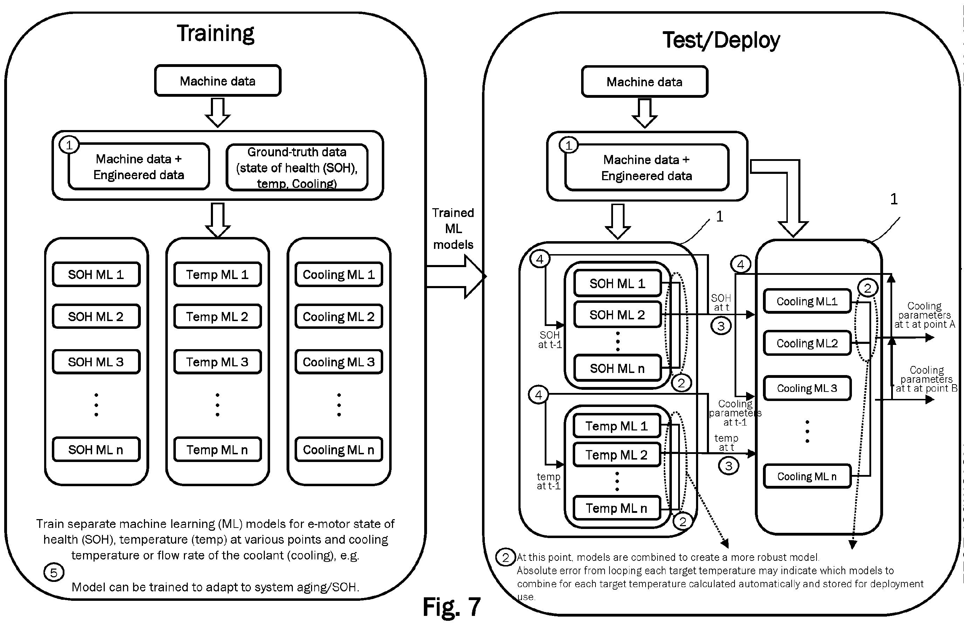

ML 1 to ML n are different machine learning models 4 with distinct objective functions, meaning that each ML model 4 has its strengths which might not be possessed by the other ML models 4. These distinct ML models 4 are trained to estimate each of the temperature targets (target points), so ML 1 is trained to estimate all pre-defined temperature target points of the e-motor. Note that all models 4 may not perform equally in estimating each of the temperature targets. After the ML models 4 are trained, the accuracy or capability of the trained models 4 are evaluated on new batches of (unseen) data as shown in the steps "1","2" of the right-side box of Fig.6 during the "testing" part. Then, ML models 4 that perform well for a given temperature target point are selected and grouped (step "3" in the right-side box) as a subset 5 for estimating/determining a temperature target point. Note that an ML model i can be found in different subsets 5 for estimating different temperature target p, if ML model i meets the accuracy criteria set for the temperature target p. The combinations/subsets 5 are indicated in Fig. 6 by the differently shaped arrows/lines at the output of the MLLMLn I in the testing section of Fig.6. Specifically, here it is shown that (as a non-limiting example) three subsets are formed which include ML1+ML2 (finely broken lines), ML1+MLn (dot-broken line) and ML3+MLn (coarsely broken line) which each output a determination value in step "4" in the right-side box (testing) of Fig. 6. The output is provided to the outside of the device 1 and real-time temperature estimation/determination results can be displayed or input to another entity (as explained in connection with Fig.7, for example). After the assembly of the subsets 5, the device 1 is ready for use.

Note that during the temperature determination procedure, the determined temperatures at t-1 (or at t-2, t-3, and/or so on) may be automatically looped back into the models 4 for use in making temperature determination at time t. For the number of temperature target points p there is preferably an equivalent number of subsets 5 . The output of each determination unit/ML model 4 within a subset 5 may be combined to a single input, e.g. by calculating an average or a weighted average or the like.

Hence, a relatively simple training and testing procedure is provided for assembling and testing the device 1, which may, e.g., serve as a virtual sensor or a virtual controller. In this connection it is advantageous that original sensor data or machine data can be engineered for creating a new batch of useful data to train the ML models. Preferably, further, a looping back of results for each determination unit/ML model can be provided. Further, the selection and combining of determination units3 /ML models 4 can be automatized, for example, by evaluating the prediction errors of each of the models 4 for each of the target/output; and the output of each subset 5 from a set 2 of models 4 (automatically) selected in step "3" shown in Fig.6 are combined to produce a final single output for the temperature of a target point. This approach makes the resulting output more resilient to errors that could occur if a single model 4 was used for a target point.

It is furthermore noted that in case of the above example and the electric motor temperature evaluation at, e.g., 54 target points, the following data may be used as input data during the operation of the device 1 and/or as training data. The following data can also be used for the input in regard of SOH and cooling determination as training data and/or as data during the operation of the device and system as disclosed.

For example, the list of input data during the training of the example as shown in Fig. 6, being directly measured (or numerically simulated) in an experiment or so, may include one or more of: Ambient Temperature, Temperature measurements (at 54 target points, which is an example and the number may be higher or lower), coolant (oil) temperature, coolant (oil) flow rate at rotor, coolant (oil) flow rate at stator A side, coolant (oil) flow rate at stator B side, speed, motor revolution, operation time, electrical voltage (at various points), electrical current (at predefined various points); further the input data may include values of measurement derived values, including: Torque (at predefined various points), electric power, force, pressure, pressure times speed, pressure times speed times time, electrical voltage times current (at predefined various points), previous temperatures (at the 54 different target points).

Then, during the operation and testing of a device 1 which can determine temperature, as shown on the right side of Fig. 6, the list of input data includes the input data as listed above, however, excluding the temperature measurement values ("target temperatures" in Fig. 6; because they will be determined by the determination units).

The set of models included in the determination units (preferably each determination unit includes one model or one model combination) may comprise the following algorithms (non-exhaustive and non-limiting list of examples) adaBoostRegressor, LinearRegression, HistGradientBoostingRegressor, BayesianRidge, XGBoostRegressor, Lasso, Extra Tree Regressor + Bagging Regressor, Gradient Boosting Regressor, Decision Tree Regressor, Support Vector Regressor (SVR), MLP Regressor (Neural Network), Random Forest Regressor, HuberRegressor, ARDRegression, RidgeCV, hybrid of several combinations of the above.

Furthermore, the steps of Fig.6 are again explained below based on more specific examples and in different words specifically focused on the selection of ML models 4 for the sets 2 and subsets 5 as described before:
The selection of the ML models 4 for a target point may include the step 1 of training, testing and validating the ML models 4. Then, in the step 2, the evaluation of the errors associated with the models 4 in step 1 and selecting only those models 4 that meet pre-defined accuracy and robustness requirements is performed. The selected number of models 4 is depicted as n. In such way a pre-selection of ML models 4 for assembling a set 2 of determination units 3 with ML models 4 can be realized. Now, assuming for this example, that there are only four ML models 4 in step 1, namely ARDRegression model, LinearRegression model, BayesianRidge model and Lasso model, which would qualify to be pre-selected for a set 2 of ML models 4 for determining temperature. In this example, again, the target is to predict 54 temperature target points (Temp_ID) for the entire operation such that the count of the absolute error more than 5degrees Celcius is not more than 10%. This means that throughout the operation, the selected ML model 4 should not make mistakes with absolute error more than 5degrees Celcius for at least 90% of the time.

So, looking at the result table 1 below, ARDRegression, LinearRegression, BayesianRidge models 4 satisfy the requirement for some of the temperature target points, while Lasso satisfies the requirement only at 5 temperature target points. Assuming for this example that there are only these four ML models 4 pre-selected for the set 2, it may be considered to eliminate Lasso, too. These pre-selected three ML models 4 may then be part of the set 2 for determining temperature and based on which a subset 5 for each target point may be combined/assembled as previously described. However, of course, the set of ML models/determination units may also include a large number of ML models 4 which have not been specifically pre-selected as described in the paragraph above so that only subsets 5 are assembled based on the selection process described in connection with the above Figures 1 to 4. In other words, the above described error-criterion-based pre-selection step for assembling a set 2 for a certain parameter may be skipped and all possibly available models 4 may be assembled to form a set 2 or a random/knowledge-based "pre-selection" of models 4 may be performed to assemble a set 2.

**Table 1**

| | Temp_ID | Percentage_error_5_percent_ard | Percentage_error_5_percent_LinReg | Percentage_error_5_percent_BayRidge | Percentage_error_5_percent_Las |
|---|---|---|---|---|---|
| 1 | B02 | 49.36821104 | 100 | 100 | 1.745732654 |
| 2 | Rail1 | 100 | 100 | 100 | 2.394147639 |
| 3 | Rail2 | 100 | 100 | 100 | 3.158944802 |
| 4 | Rail3 | 100 | 100 | 100 | 2.649080027 |
| 5 | H01 | 78.45821326 | 100 | 100 | 14.09332742 |
| 6 | H02 | 70.82686766 | 100 | 100 | 2.5659499 |
| 7 | H03 | 96.39215252 | 100 | 100 | 3.546885391 |
| 8 | B01 | 53.58013744 | 100 | 100 | 1.884282864 |
| 9 | SB08 | 57.8308579 | 100 | 100 | 5.270450011 |
| 10 | SB13 | 94.00354689 | 34.37707825 | 34.37707825 | 2.837508313 |
| 11 | F01 | 100 | 56.86654844 | 56.87209045 | 5.38129018 |
| 12 | SB01 | 97.51718023 | 39.59765019 | 39.59765019 | 2.338727555 |
| 13 | SB04 | 70.43338506 | 100 | 100 | 4.527820882 |
| 14 | SB05 | 82.98603414 | 37.53048105 | 37.54156506 | 2.338727555 |
| 15 | NTC4 | 60.27488362 | 27.46619375 | 27.46619375 | 99.22966083 |
| 16 | NTC2 | 75.98093549 | 37.71336732 | 37.71336732 | 100 |
| 17 | NTC3 | 78.13677677 | 38.14564398 | 38.14564398 | 25.9199734 |
| 18 | PT100 | 100 | 100 | 100 | 100 |
| 19 | NTC1 | 63.52250055 | 41.7091554 | 41.7091554 | 100 |
| 20 | C01 | 22.80536466 | 55.14852583 | 55.14852583 | 4.084460208 |
| 21 | SB07 | 49.39037907 | 74.60097539 | 74.60097539 | 4.605409 |
| 22 | SB11 | 99.94457992 | 99.94457992 | 99.94457992 | 2.266681445 |
| 23 | SB02 | 73.30414542 | 48.58124584 | 48.59232986 | 9.183107958 |
| 24 | SB03 | 44.8015961 | 31.71691421 | 31.71691421 | 4.766127245 |
| 25 | SB06 | 40.05763689 | 83.83950344 | 83.83950344 | 9.210818 |
| 26 | SA10 | 58.0913323 | 53.11460873 | 53.11460873 | 1.429838173 |
| 27 | SA11 | 73.43161162 | 30.53092441 | 30.53092441 | 1.374418089 |
| 28 | SA12 | 48.79738417 | 46.54732875 | 46.80226114 | 2.931722456 |
| 29 | SA13 | 30.02105963 | 85.49102195 | 85.44668588 | 4.400354689 |
| 30 | SA06 | 39.85812458 | 100 | 100 | 2.538239858 |
| 31 | SA07 | 20.01219242 | 100 | 100 | 4.272888495 |
| 32 | SA08 | 26.51851031 | 100 | 100 | 7.548215473 |
| 33 | SA09 | 90.67279982 | 100 | 100 | 1.529594325 |
| 34 | SA02 | 54.7993793 | 38.41166039 | 38.42828641 | 3.696519619 |
| 35 | SA03 | 33.56794502 | 72.01839947 | 72.01839947 | 3.153402793 |
| 36 | SA04 | 46.6470849 | 100 | 100 | 2.53269785 |
| 37 | SA05 | 41.39326092 | 23.12125914 | 23.12125914 | 3.807359787 |
| 38 | M07 | 0.188428286 | 0.127466194 | 0.127466194 | 3.840611838 |
| 39 | SA01 | 87.11483041 | 92.95056528 | 93.01152738 | 5.952117047 |
| 40 | M03 | 0.133008202 | 0.133008202 | 0.133008202 | 0.504322767 |
| 41 | M04 | 0.288184438 | 0.199512303 | 0.199512303 | 1.252493904 |
| 42 | H05 | 71.1815562 | 100 | 100 | 5.226113944 |
| 43 | R01 | 69.64087785 | 86.00642873 | 95.7215695 | 100 |
| 44 | RE1 | 100 | 100 | 100 | 17.67900687 |
| 45 | B03 | 100 | 99.98337397 | 99.98337397 | 4.57215695 |
| 46 | B04 | 100 | 100 | 100 | 3.923741964 |
| 47 | H04 | 100 | 59.00022168 | 59.00022168 | 11.26690313 |
| 48 | Sator_upper_outer_skin_2 | 65.34582133 | 93.91487475 | 93.92041676 | 5.94103303 |
| | 49 Sator_upper_outer_skin_4 | 63.72755487 | 100 | 100 | 6.317889603 |
| 50 | H06 | 81.34559965 | 90.83906008 | 90.83906008 | 7.592551541 |
| 51 | H07 | 57.65351363 | 100 | 100 | 5.669474618 |
| 52 | Sator_upper_outer_skin_1 | 58.1578364 | 100 | 100 | 9.210818 |
| 53 | Sator_upper_outer_skin_3 | 64.71403237 | 100 | 100 | 8.313012636 |
| | | 64.96070402 | 73.20052032 | 73.3898897 | 14.15993609 |

Furthermore, output data as shown in the Table 1 above (showing in the first column the indicators for 54 target points, and the errors for the ARDRegression, LinearRegression, BayesianRidge and Lasso models in the other four columns in this order) may be used to assemble subsets 5. For example, assuming that it is required that the count of the absolute error more than 5degrees is not more than 10%. This means that throughout an operation of a device 1, the selected ML model 4 should make mistakes with absolute error more than 5degrees for at least 90% of the time.

Looking at the above table, it means that ARDRegression would not be suitable for determining temperature at point 1 (B02, first line), whereas LinearRegression and BayesianRidge are suitable for B02. On the other hand, ARDRegression is the only model suitable for determining the temperature at point 11 (F01, line 11). Accordingly, for target point 1 (BO2) a subset 5 would be formed including LinearRegression and BayesianRidge ML models (or determination units including them), while for target point 11 the subset 5 would only include a single ML model, namely ARDRegression. This process can be performed for every target point to assemble the subsets 5, as described in more general terms in connection with the previous Figures.

Again it is noted that these examples shall not in any way limit the disclosure to this specific example. Further, as will be appreciated by one of skill in the art, the present disclosure, as described hereinabove and the accompanying figures, may be embodied as a method, an apparatus (including a device, machine, system, computer program product, and/or any other apparatus), or a combination of the foregoing.

Figure 7 shows a further preferred example according to the present disclosure in which a system including two devices 1 are combined to provide a control device which can output, in this preferred example, the cooling target value of the electric motor at different points A and B (the number of two points is an example) at a time t. The cooling target value may mean the necessary coolant temperature to be controlled by the virtual control device or an external thermal management control device or the like, the optimal operation temperature of the electric motor to be controlled by an external thermal management control device or the like, and/or the coolant flow rate to be controlled by the virtual control device 1 or an external thermal management control device or the like.

In step "1" generated real machine data is transformed and engineered before feeding them to different sets of machine learning models. In this example there are sets for SOH (SOH ML), temperature (Temp ML), and cooling (Cooling ML).

During data engineering, new features are created (derived values) from the original machine data using physical relationship and domain knowledge. For example, a feature called "I_V" is generated by multiplying current I and Voltage V. Note that the training datasets might differ for each set of the machine learning models, that is, a training dataset for SOH ML might be different for the training dataset for Temp ML, and so on.

As an illustration, there are 3 sets of ML models 4 (SOH ML, Temp ML, Cooling ML) shown in Fig.7 to be trained for: SOH of the electric motor (SOH ML), estimating the temperature of the electric motor (Temp ML), and estimating the cooling of the electric motor, wherein cooling may include the above described values for coolant temperature, coolant flow rate and or cooling target temperature to be input to an external thermal management control device. The training data of the SOH ML include real SOH values measured from experiments for different operation conditions of the electric motor including the operation conditions as well as operational parameters of the electric motor, such as efficiency, voltage input and output, electric current input and output, power input and output, age, operating hours. The training data for temperature may include, furthermore, temperature data simulated or measured of the electric motor at different operation conditions and the operation conditions, and the cooling training data may include, furthermore, measure or simulated cooling data as well as their operational conditions for different operational conditions of the electric motor as well as the resulting temperature values of the electric motor achieved by the cooling values; the cooling values preferably including at least one of coolant flow rate of the heat exchanger/cooler part of the electric motor, coolant temperature or optimal temperature of the electric motor to be achieved. Most preferably, the coolant is input into to electric motor at one, two or more positions so that a cooling control value is provided for each of the two or more positions.

More specifically, during the training of the SOH ML, the TEMP ML and the Cooling ML in the example of Figur 7, the input data for training are: Ambient Temperature, coolant (oil) temperature, coolant (oil) flow rate at rotor, coolant (oil) flow rate at stator A side, coolant (oil) flow rate at stator B side, speed, motor revolution, operation time, electrical voltage (at various points), electrical current (at predefined various points). Further the input data may include values of measurement derived values, including: Torque (at predefined various points), electric power, force, pressure, pressure times speed, pressure times speed times time, electrical voltage times current (at predefined various points), previous temperatures (at e.g. 54 different target points). In addition, during the training, the Temp MLs receive measured temperature values for each target point, the SOH MLs receive the measured or measurement-derived target values of SOH and the "cooling" values measured or derived from measurements. Then, during the testing and the operation of the system as shown in Fig. 7, the latter mentioned measurements values, i.e. for temperature, SOH and cooling are not part of the input data because they are determined by the trained MLs, as shown in Fig. 7.

Each set of ML model 4 (e.g., Temp ML) comprises different machine learning models 4 (e.g., Temp ML 1, Temp ML 2, ..., Temp ML n) with distinct objective function, meaning that each ML model 4 has its strengths which might not be possessed by the other ML models. These distinct ML models 4 are trained to estimate the target output (e.g., temperature).

After the ML models 4 in each set 2 of machine learning models 4 (SOH ML, Temp ML, Cooling ML) are trained for specific targets (SOH, Temperature, Cooling) (left side of Fig.7), the accuracy or capability of the trained models 4 is evaluated with a new dataset (step "1" on the right hand side of Fig.7). Then, for each model set 2 (targeting a specific target, e.g., Temp ML 1, Temp ML 2, ..., Temp ML n), ML models 4 that perform well for this given target are selected and grouped as subset 5 of models w for determining this target parameter at a specific target point (e.g., temperature of the electric motor at a target point). Looping back can be performed as described before in both devices (see steps "4" in Fig. 7). Further, it is noted that in Fig.7 on the right hand side, two devices 1 both receive the input data (see the bold arrows in the test box in Fig. 7) so that the assembly of the subsets 5 based on the accuracy of the output of each ML model 4 can be performed for all ML models/determination units 3 of both devices 1, wherein the one device 1 includes two sets of ML models/determination units 3, one for temperature as the physical parameter to be determined and one for SOH of the electric motor as the physical parameter to be determined, while the other device 1 includes one set of ML models/determination units 3 for determining the control parameter "cooling", such as coolant flow rate or temperature as explained above, in this preferred example.

Further, as one can see from the steps "3" in Fig. 7, the output values of the one device 1 (temperature and SOH of the electric motor) are used as (part of) input values/data for the other device 1 based on which the ML models 4 for "Cooling" determine, inter alia, the cooling value as a control parameter to be output to the heat exchanger of the electric motor, its control unit or another controller, such as thermal management controller of the electric motor, or the like. In addition to the values output by the previous device 1, the input data to the second device 1 may further include, as shown in Fig. 7, the same input data as to the first device 1, i.e. ground truth data and the like.

It is further noted that a further training in a later step "5" can be performed at any time, e.g., in order to adapt the ML models 4 to an ageing of the components or the like. In this connection it is noted that the same training data may be used whereas actual ground truth data (such as measurement or simulated data of SOH, temperature of the electric motor at the target points, and cooling values at target points, such as A and B in Fig. 7) are used for the "retraining" which allows adapting the MLs to the actual state of the electric motor.

The following further technical advantages are achieved which have not been addressed before, including, in the example of determining the cooling control value(s), the respective device 1 gets temperature and SOH determination data directly from ML-based models trained to estimate temperatures and SOH of the electric motor; and ML models 4 can be trained to automatically adjust themselves over time due to system aging of the electric motor.

It is furthermore noted that embodiments of the present disclosure may take the form of an entirely hardware embodiment, an entirely software embodiment (including firmware, resident software, microcode, etc.), or an embodiment combining software and hardware aspects that may generally be referred to herein as a "system". Furthermore, embodiments of the present disclosure may take the form of a computer program product on a computer-readable medium having computer-executable program code embodied in the medium.

It should be noted that arrows may be used in drawings to represent communication, transfer, or other activity involving two or more entities. Double-ended arrows generally indicate that activity may occur in both directions (e.g., a command/request in one direction with a corresponding reply back in the other direction, or peer-to-peer communications initiated by either entity), although in some situations, activity may not necessarily occur in both directions.

Single-ended arrows generally may indicate activity exclusively or predominantly in one direction, although it should be noted that, in certain situations, such directional activity actually may involve activities in both directions (e.g., a message from a sender to a receiver and an acknowledgement back from the receiver to the sender, or establishment of a connection prior to a transfer and termination of the connection following the transfer). Thus, the type of arrow used in a particular drawing to represent a particular activity is exemplary and should not be seen as limiting.

Aspects are described hereinabove with reference to flowchart illustrations and/or block diagrams of methods and apparatuses, and with reference to a number of sample views of a graphical user interface generated by the methods and/or apparatuses. It will be understood that each block of the flowchart illustrations and/or block diagrams, and/or combinations of blocks in the flowchart illustrations and/or block diagrams, as well as the graphical user interface, can be implemented by computer-executable program code.

The computer-executable program code may be provided to a processor of a general purpose computer, special purpose computer, or other programmable data processing apparatus to produce a particular machine, such that the program code, which executes via the processor of the computer or other programmable data processing apparatus, create means for implementing the functions/acts/outputs specified in the flowchart, block diagram block or blocks, figures, and/or written description.

These computer-executable program code may also be stored in a computer-readable memory that can direct a computer or other programmable data processing apparatus to function in a particular manner, such that the program code stored in the computer readable memory produce an article of manufacture including instruction means which implement the function/act/output specified in the flowchart, block diagram block(s), figures, and/or written description.

The computer-executable program code may also be loaded onto a computer or other programmable data processing apparatus to cause a series of operational steps to be performed on the computer or other programmable apparatus to produce a computer-implemented process such that the program code which executes on the computer or other programmable apparatus provides steps for implementing the functions/acts/outputs specified in the flowchart, block diagram block(s), figures, and/or written description. Alternatively, computer program implemented steps or acts may be combined with operator or human implemented steps or acts in order to carry out an embodiment.

It should be noted that terms such as "server" and "processor" may be used herein to describe devices that may be used in certain embodiments and should not be construed to limit to any particular device type unless the context otherwise requires. Thus, a device may include, without limitation, a bridge, router, bridge-router (b-router), switch, node, server, computer, appliance, or other type of device. Such devices typically include one or more network interfaces for communicating over a communication network and a processor (e.g., a microprocessor with memory and other peripherals and/or application-specific hardware) configured accordingly to perform device functions.

Communication networks generally may include public and/or private networks; may include local-area, wide-area, metropolitan-area, storage, and/or other types of networks; and may employ communication technologies including, but in no way limited to, analogue technologies, digital technologies, optical technologies, wireless technologies (e.g., Bluetooth), networking technologies, and internetworking technologies.

It should also be noted that devices may use communication protocols and messages (e.g., messages created, transmitted, received, stored, and/or processed by the device), and such messages may be conveyed by a communication network or medium.

Unless the context otherwise requires, the present disclosure should not be construed as being limited to any particular communication message type, communication message format, or communication protocol. Thus, a communication message generally may include, without limitation, a frame, packet, datagram, user datagram, cell, or other type of communication message.

Unless the context requires otherwise, references to specific communication protocols are exemplary, and it should be understood that alternative embodiments may, as appropriate, employ variations of such communication protocols (e.g., modifications or extensions of the protocol that may be made from time-to-time) or other protocols either known or developed in the future.

It should also be noted that logic flows may be described herein to demonstrate various aspects and should not be construed to limit the disclosure to any particular logic flow or logic implementation. The described logic may be partitioned into different logic blocks (e.g., programs, modules, functions, or subroutines) without changing the overall results.

Often times, logic elements may be added, modified, omitted, performed in a different order, or implemented using different logic constructs (e.g., logic gates, looping primitives, conditional logic, and other logic constructs) without changing the overall results.

The present disclosure may be embodied in many different forms, including, but in no way limited to, computer program logic for use with a processor (e.g., a microprocessor, microcontroller, digital signal processor, or general purpose computer), programmable logic for use with a programmable logic device (e.g., a Field Programmable Gate Array (FPGA) or other PLD), discrete components, integrated circuitry (e.g., an Application Specific Integrated Circuit (ASIC)), or any other means including any combination thereof Computer program logic implementing some or all of the described functionality is typically implemented as a set of computer program instructions that is converted into a computer executable form, stored as such in a computer readable medium, and executed by a microprocessor under the control of an operating system. Hardware-based logic implementing some or all of the described functionality may be implemented using one or more appropriately configured FPGAs.

Computer program logic implementing all or part of the functionality previously described herein may be embodied in various forms, including, but in no way limited to, a source code form, a computer executable form, and various intermediate forms (e.g., forms generated by an assembler, compiler, linker, or locator).

Source code may include a series of computer program instructions implemented in any of various programming languages (e.g., an object code, an assembly language, or a high-level language such as Fortran, C, C++, JAVA, or HTML) for use with various operating systems or operating environments. The source code may define and use various data structures and communication messages. The source code may be in a computer executable form (e.g., via an interpreter), or the source code maybe converted (e.g., via a translator, assembler, or compiler) into a computer executable form.

Computer-executable program code for carrying out operations of embodiments of the present disclosure may be written in an object oriented, scripted or unscripted programming language such as Java, PerI, Smalltalk, C++, or the like. However, the computer program code for carrying out operations of embodiments may also be written in conventional procedural programming languages, such as the "C" programming language or similar programming languages.

Computer program logic implementing all or part of the functionality previously described herein may be executed at different times on a single processor (e.g., concurrently) or may be executed at the same or different times on multiple processors and may run under a single operating system process/thread or under different operating system processes/threads.

Thus, the term "computer process" may refer generally to the execution of a set of computer program instructions regardless of whether different computer processes are executed on the same or different processors and regardless of whether different computer processes run under the same operating system process/thread or different operating system processes/threads.

The computer program may be fixed in any form (e.g., source code form, computer executable form, or an intermediate form) either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

The computer program may be fixed in any form in a signal that is transmittable to a computer using any of various communication technologies, including, but in no way limited to, analog technologies, digital technologies, optical technologies, wireless technologies (e.g., Bluetooth), networking technologies, and internetworking technologies.

The computer program may be distributed in any form as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web).

Hardware logic (including programmable logic for use with a programmable logic device) implementing all or part of the functionality previously described herein may be designed using traditional manual methods, or may be designed, captured, simulated, or documented electronically using various tools, such as Computer Aided Design (CAD), a hardware description language (e.g., VHDL or AHDL), or a PLD programming language (e.g., PALASM, ABEL, or CUPL).

Any suitable computer readable medium may be utilized. The computer readable medium may be, for example but not limited to, an electronic, magnetic, optical, electromagnetic, infrared, or semiconductor system, apparatus, device, or medium.

More specific examples of the computer readable medium include, but are not limited to, an electrical connection having one or more wires or other tangible storage medium such as a portable computer diskette, a hard disk, a random access memory (RAM), a read-only memory (ROM), an erasable programmable read-only memory (EPROM or Flash memory), a compact disc read-only memory (CD-ROM), or other optical or magnetic storage device.

Programmable logic may be fixed either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), or other memory device.

The programmable logic may be fixed in a signal that is transmittable to a computer using any of various communication technologies, including, but in no way limited to, analogue technologies, digital technologies, optical technologies, wireless technologies (e.g., Bluetooth), networking technologies, and internetworking technologies.

The programmable logic may be distributed as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web). Of course, some aspects may be implemented as a combination of both software (e.g., a computer program product) and hardware. Still other embodiments of the may be implemented as entirely hardware, or entirely software.

While certain exemplary aspects have been described and shown in the accompanying drawings, it is to be understood that such aspects are illustrative, and that the embodiments are not limited to the specific constructions and arrangements shown and described, since various other changes, combinations, omissions, modifications and substitutions, in addition to those set forth in the above paragraphs, are possible.

Those skilled in the art will appreciate that various adaptations, modifications, and/or combination of the just described embodiments can be configured. Therefore, it is to be understood that, within the scope of the appended claims, the disclosure may be practiced other than as specifically described herein. For example, unless expressly stated otherwise, the steps of processes described herein may be performed in orders different from those described herein and one or more steps may be combined, split, or performed simultaneously. Those skilled in the art will also appreciate, in view of this disclosure, that different embodiments or aspects described herein may be combined to form other embodiments.

## Claims

1. A device for determining values of parameters related to a machine, the device comprising
an input interface (1a) for receiving input data;
one or more sets (2) of determination units (3), wherein
each set (2) includes a plurality of determination units (3) and each determination unit (3) within one set (2) is configured to determine a value of a predetermined parameter for a target point based on the received input data, and wherein
one or more determination units (3) from one set (2) are combined to a subset (5) of determination units (3) and each subset (5) is configured to determine a value of the predetermined parameter for a target point associated to the subset (5); and
an output interface (1b) for outputting a value determined by the subset (5).

2. The device according to claim 1, wherein each determination unit (3) comprises a trained machine learning model (4).

3. The device according to claim 2, wherein each determination unit (3) of one set (2) comprises a different machine learning model (4).

4. The device according to at least one of the previous claims, wherein the device (1) is further configured to input a value determined by a subset (5) for a first time epoch as input data to said subset (5) for determining a value for a second epoch that follows the first epoch.

5. The device according to at least one of the previous claims, wherein the device (1) includes one set (2) of determination units (3) for each parameter for which values are to be determined.

6. The device according to at least one of the previous claims, wherein for each target point of a parameter to be determined the device (1) includes a subset (5), wherein the subset (5) comprises a combination of determination units (3) that are selected from said each set (2) of determination units (3) and that provide determined values within a predefined error margin.

7. The device according to claim 6, wherein the selection of the combination of determination units (3) is automated based on pre-defined selection criteria.

8. The device according to at least one of the previous claims, wherein a subset (5) is configured to:
determine a combined value on the basis of values determined by the determination units (3) of said subset (5), and
output said combined value as determination result for the target point of said subset (5).

9. The device according to claim 8, wherein the combined value is determined by calculating an average value of the determined values provided by the determinations units (3) of a subset (5).

10. The device according to claim 9, wherein said combined value is an weighted average value of determined values.

11. The device according to at least one of the previous claims, wherein the machine is an electric motor, the device (1) determining the temperature of the electric motor as the predetermined parameter, and the device (1) includes a plurality of subsets (5) each determining the temperature of the electric motor at one of a plurality of target points, and wherein the input data include an ambient temperature value and the electric motor operational condition of the electric motor.

12. A system including at least two devices (1) according to at least one of the previous claims.

13. The system according to claim 12, wherein at least one of the devices (1) is configured to determine values of physical parameters of the machine and input the determined values into another of the devices (1) as input data, and the other device (1) is configured to determine values of one or more control parameters of the machine.

14. The system according to claim 13, wherein the machine is an electric motor, and the system includes two devices (1),
one device (1) including two sets (2), with one set (2) for determining an SOH value of the electric motor and one set (2) for determining the temperature value of a plurality of target points of the electric motor, and wherein the input data to said device (1) include an ambient temperature value and the electric motor operational condition of the electric motor, and wherein said device configured to output the determined temperature values and the determined SOH value and to input the values into the other of the two devices (1),
the other device (1) including a set (2) for determining, based on the input, cooling values for at least one target point.

15. A method for assembling a device (1) according to at least one of claims 1 to 11, comprising the steps:
- providing for each parameter of a machine a set (2) of determination units (3) each including a machine learning model (4),
- assembling for each target point of each parameter of the machine a subset (5) of determination units (3) by selecting one or more determination units of the set (2) of determination units (3),
- wherein the selection of determination units (3) is performed by comparing values determined by the determination units (3) for the parameter for the target point with measurement data and wherein one or more determination units (3) are selected from the set (2) if the determined value of a determination unit (3) is within a predefined error margin compared to the measurement data.

16. The method accordingto claim 15, wherein the machine learning models (4) are trained by inputting training data before providingthem into a set (2) of determination units (3), wherein determination units (3) are provided into a set (2) if the included machine learning model (4) reproduces measurement data of a parameter of a machine within a pre-defined error margin.

17. A computer program comprising instructions which, when the program is executed by a computer, cause the computer to act as the device (1) according to at least one of claims 1 to 11.
